# EUROPÄISCHE PATENTSCHRIFT

(11) **EP 3 601 643 B1**
(45) Veröffentlichungstag und Bekanntmachung des Hinweises auf die Patenterteilung: **27.09.2023**
(21) Anmeldenummer: 18712202.3
(22) Anmeldetag: 19.03.2018
(51) Int. Cl.: C23C 14/50, C23C 14/56, C23C 16/458, C23C 16/24, C23C 16/44, C23C 16/54, H01L 21/677, C30B 25/12

(54) **PROZESSKAMMERFÜHRUNG, PROZESSKAMMER UND VERFAHREN ZUM FÜHREN EINES SUBSTRATTRÄGERS IN EINE PROZESSPOSITION**
PROCESS CHAMBER GUIDE, PROCESS CHAMBER, AND METHOD FOR GUIDING A SUBSTRATE CARRIER IN A PROCESS POSITION
SYSTÈME DE GUIDAGE DE CHAMBRE DE TRAITEMENT, CHAMBRE DE TRAITEMENT ET PROCÉDÉ POUR GUIDER UN SUPPORT DE SUBSTRAT DANS UNE POSITION DE TRAITEMENT

(30) Priorität: 24.03.2017 DE 102017106373
(43) Veröffentlichungstag der Anmeldung: 05.02.2020
(73) Patentinhaber: Nexwafe GmbH, 79108 Freiburg (DE)
(72) Erfinder: REBER, Stefan, 79194 Gundelfingen (DE); SCHILLINGER, Kai, 79106 Freiburg (DE); REICHART, Benjamin, 79312 Emmendingen-Wasser (DE)
(74) Vertreter: LBP Lemcke, Brommer & Partner Patentanwälte mbB
(86) Internationale Anmeldenummer: PCT/EP2018/056873
(87) Internationale Veröffentlichungsnummer: WO 2018/172277

(56) Entgegenhaltungen:
- WO-A1-92/17621
- WO-A1-2015/127191
- DE-A1-102009 038 369
- DE-A1-102010 052 761
- DE-A1-102011 106 859
- JP-A- H11 158 630
- US-A- 5 814 196
- US-A1- 2004 076 506
- US-A1- 2015 024 540

## Beschreibung

Die Erfindung betrifft eine Prozesskammer und ein Verfahren zum Führen eines Substratträgers in eine Prozessposition.

Bei der Beschichtung von Substraten, wie beispielsweise zum Abscheiden von Halbleiterschichten auf ein Saatsubstrat, finden Substratträger Anwendung: Die Saatsubstrate werden auf dem Substratträger angeordnet. Anschließend wird der Substratträger mittels einer Prozesskammerführung in eine Prozessposition gebracht.

Es ist bekannt, eine untere und eine obere Prozesskammerführung für Substratträger vorzusehen, sodass die Substratträger parallel in den Prozesskammerführungen verschoben werden können und in der Prozessposition eine Prozesskammer ausgebildet ist, welche seitlich durch die Substratträger sowie nach oben und unten durch die Prozesskammerführungen abgegrenzt ist. Eine solche Vorrichtung ist aus WO 2013/004851 A1 bekannt.

Aus der DE 10 2011 106 859 A1 ist eine Prozesskameraführung mit einem verschiebbaren Substratträger entlang einer Führungsrichtung bekannt, wobei der Substratträger in Schienen geführt wird.

Der vorliegenden Erfindung liegt die Aufgabe zugrunde, die vorbekannte Prozesskammerführung zu verbessern, um verbesserte Prozessbedingungen zu ermöglichen.

Gelöst ist diese Aufgabe durch eine Prozesskammer gemäß Anspruch 1, eine Vorrichtung zum chemischen Abscheiden einer Schicht auf einem Substrat gemäß Anspruch 14 und ein Verfahren zum Führen eines Substratträgers in eine Prozessposition gemäß Anspruch 15. Vorteilhafte Ausgestaltungen finden sich in den abhängigen Ansprüchen.

Die Prozesskammer ist bevorzugt zur Durchführung des erfindungsgemäßen Verfahrens ausgebildet, insbesondere einer vorteilhaften Ausführungsform hiervon. Das erfindungsgemäße Verfahren ist bevorzugt zum Durchführen mittels der erfindungsgemäßen Prozesskammer ausgebildet, insbesondere einer bevorzugten Ausführungsform hiervon.

Die erfindungsgemäße Prozesskammer ist ausgebildet zum geradlinigen Führen eines in der Prozesskammerführung verschiebbaren Substratträgers in einer Führungsrichtung. Hierdurch kann mittels Verschieben des Substratträgers in eine Prozessposition eine zumindest bereichsweise Abgrenzung der Prozesskammer durch Prozesskammerführung und Substratträger ausgebildet werden.

Ein Beispiel hierfür ist aus WO 2013/004851 A1 bekannt, mit einer als Schiene ausgebildeten Prozesskammerführung, in welcher ein Substratträger verschiebbar ist (siehe Figur 1 der WO 2013/004851 A1). Substratträger und Schiene bilden eine bereichsweise Abgrenzung einer Prozesskammer.

Wesentlich ist, dass bei der vorliegenden Erfindung die Prozesskammerführung zumindest eine Abdichtungsfläche, welche sich parallel zu der Führungsrichtung erstreckt und derart ausgebildet und angeordnet ist, dass bei in der Prozesskammerführung angeordnetem Substratträger in Prozessposition die Abdichtungsfläche zumindest 0,02 mm und weniger als 1 mm, bevorzugt weniger als 0,5 mm, insbesondere weniger als 0,2 mm von dem Substratträger beabstandet ist und dass der Substratträger einen Abdichtungssteg aufweist, welcher sich in Führungsrichtung erstreckt und derart angeordnet ist, dass in Prozessposition der Abdichtungssteg um weniger als 0,5 mm von der Prozesskammerführung beabstandet ist.

Die Erfindung ist in der Erkenntnis begründet, dass bisherige Prozesskammerführungen Nachteile aufweisen: Beispielsweise können bei reinen Gleitführungen in die Prozesskammerführung gelangende Partikel zur Schwergängigkeit oder zum Blockieren führen. Ebenfalls kann Abrieb entstehen, der in die Prozesskammer gelangen und dort zur Qualitätsminderung der abzuscheidenden Schicht führen kann. Durch die Abdichtungsfläche, welche weniger als 1 mm, bevorzugt weniger als 0,5 mm von dem Substratträger beabstandet ist, ist eine ausreichende Abdichtung zwischen Substratträger und Prozesskammerführung gewährleistet, sodass nur geringfügig Prozessgase zwischen Substratträger und Abdichtungsfläche hindurchtreten können. Durch den Abdichtungssteg am Substratträger wird ein zusätzliches Abdichten und somit eine Erhöhung der Abdichtungswirkung zwischen Substratträger und Prozesskammerführung erzielt. Zudem verhindert dieser Abdichtungssteg ein Eindringen oder Ausblasen von Partikeln insbesondere in bzw. aus einer Führungsnut.

Die Abdichtungsfläche dient somit zum zumindest näherungsweisen Abdichten zwischen Prozesskammerführung und dem sich in Prozessposition in der Prozesskammerführung befindenden Substratträger.

Um die Abdichtungswirkung zu verbessern ist es vorteilhaft, dass die Abdichtungsfläche senkrecht zur Führungsrichtung und parallel zur Oberfläche eines in der Prozesskammerführung angeordneten Substratträgers eine Breite von zumindest 2 mm, insbesondere zumindest 10 mm, bevorzugt zumindest 20 mm aufweist.

Um einen Kontakt zwischen einem in der Prozesskammerführung geführten Substratträger und der Abdichtungsfläche zu vermeiden, ist die Prozesskammerführung vorteilhafterweise derart ausgebildet, dass in Prozessposition die Abdichtungsfläche einen Abstand von zumindest 0,05 mm, bevorzugt zumindest 0,1 mm zu der der Abdichtungsfläche zugewandten Oberfläche des Substratträgers aufweist.

Der Abstand zwischen Abdichtungsfläche und der zugewandten Oberfläche des Substratträgers wird bevorzugt mit Führungselementen erzielt, welche an der Prozesskammerführung und/oder an dem Substratträger angeordnet sein können. Die Führungselemente können als Führungsleisten, Führungsrollen und/oder Führungsrinnen, insbesondere als Nut ausgebildet sein.

In Führungsrichtung erstreckt sich die Abdichtungsfläche vorteilhafterweise über eine ausreichende Länge, um die Ausbildung einer Prozesskammer zu ermöglichen, insbesondere zumindest über die Breite eines Substratträgers in Führungsrichtung. Bevorzugt erstreckt sich die Abdichtungsfläche zumindest über 0,5 m, insbesondere bevorzugt zumindest über 1 m.

Insbesondere ist es vorteilhaft, dass sich die Abdichtungsfläche über die gesamte Länge der Prozesskammerführung in Führungsrichtung erstreckt.

Vorteilhafterweise weist die Prozesskammerführung zusätzlich zu der genannten ersten Abdichtungsfläche zumindest eine zweite Abdichtungsfläche auf, welche sich parallel zu der Führungsrichtung erstreckt und derart ausgebildet und angeordnet ist, dass bei in der Prozesskammerführung angeordnetem Substratträger in Prozessposition der Substratträger zwischen den beiden Abdichtungsflächen angeordnet ist und die Abdichtungsflächen senkrecht zur Führungsrichtung einen Abstand aufweisen, der die Dicke des Substratträgers um weniger als 1 mm, bevorzugt um weniger als 0,4 mm, insbesondere um weniger als 0,2 mm übersteigt. Hierdurch wird die Abdichtungswirkung erhöht.

Vorteilhafterweise weist die Prozesskammerführung eine Rollenlagerung für den Substratträger auf. Insbesondere aufgrund von Temperaturunterschieden während der Prozessierung können Formveränderungen von Substratträger und/oder Prozesskammerführung auftreten, welche zu einem Verklemmen des Substratträgers in der Prozesskammerführung oder zu einem ungenügenden Abdichten zwischen Prozesskammerführung und Substratträger führen. Die Rollenlagerung vermeidet diese Nachteile, indem mittels der Rollenlagerung eine gute Beweglichkeit des Substratträgers in Führungsrichtung auch bei räumlichen oder zeitlichen Temperaturgradienten gegeben ist.

Die Rollenlagerung kann alternativ an dem Substratträger angeordnet sein. Ebenso liegt es im Rahmen der Erfindung, dass sowohl Prozesskammerführung, als auch Substratträger eine Rollenlagerung aufweisen.

Vorteilhafterweise sind mit der Rollenlagerung zusammenwirkende Führungselemente vorgesehen, welche eine seitliche Verschiebung senkrecht zur Führungsrichtung verhindern. Diese Führungselemente können wie zuvor beschrieben als Führungsleisten, Führungsrollen und/oder Führungsrinnen, insbesondere als Nut ausgebildet sein. Bevorzugt sind die Führungselemente an dem der Rollenlagerung korrespondierenden Element angeordnet: Bei an dem Führungselement angeordneter Rollenlagerung sind die Führungselemente bevorzugt an dem Substratträger angeordnet, insbesondere an der in Prozessposition der Rollenlagerung zugewandten Seite. Bei an dem Substratträger angeordneter Rollenlagerung sind die Führungselemente bevorzugt an der Prozesskammerführung angeordnet, insbesondere an der in Prozessposition der Rollenlagerung zugewandten Seite.

Vorteilhafterweise weist die Prozesskammerführung eine Nut zur Aufnahme des Substratträgers auf. Hierdurch kann in vorteilhafter Weise die Abdichtungsfläche in oder an einer Seitenwand der Nut ausgebildet werden. Vorteilhafterweise ist die Nut als rechteckige Nut ausgebildet. Es liegt im Rahmen der Erfindung, dass die Nut abgerundete Kantenbereiche aufweist.

Insbesondere ist es somit vorteilhaft, dass eine der Seitenflächen der Nut, bevorzugt beide Seitenflächen der Nut, zumindest in Teilbereichen, vorteilhafterweise über die gesamte Länge der Nut in Führungsrichtung als Abdichtungsfläche ausgebildet sind.

Eine Rollenlagerung ist vorteilhafterweise an der Bodenfläche der Nut angeordnet. Alternativ ist die Bodenfläche der Nut als Abrollfläche für eine Rollenlagerung des Substratträgers ausgebildet.

Die vorliegende Erfindung betrifft weiterhin eine Prozesskammer zur Gasphasenabscheidung von Schichten mit zumindest einer erfindungsgemäßen Prozesskammerführung, insbesondere einer vorteilhaften Ausführungsform hiervon und zumindest mit einem Substratträger. Mittels Verschieben des Substratträgers in der Prozesskammerführung in eine Prozessposition ist eine zumindest bereichsweise Abgrenzung der Prozesskammer ausbildbar. Die Prozesskammer weist an zwei gegenüberliegenden Seiten Stirnabgrenzungselemente auf, welche mit der Prozesskammerführung verbunden sind.

Die Stirnabgrenzungselemente sind bevorzugt derart angeordnet, dass in Prozessposition an zwei gegenüberliegenden Seiten eine Abgrenzung der Prozesskammer stirnseitig durch die Stirnabgrenzungselemente erfolgt, wohingegen seitlich eine Abgrenzung der Prozesskammer durch den Substratträger und die Prozesskammerführung erfolgt.

Der Substratträger weist bevorzugt eine Führung für Rollen der Rollenlagerung der Prozesskammerführung auf. Insbesondere ist es vorteilhaft, dass der Substratträger eine Nut, bevorzugt eine rechteckige Nut zur Führung der Rollen der Prozesskammerführung aufweist. Hierdurch ist ein sicheres Führen des Substratträgers bei Verschieben in der Prozesskammerführung gewährleistet. Insbesondere wird durch die Führung des Substratträgers für die Rollen ein seitliches Verschieben senkrecht zur Führungsrichtung vermieden oder zumindest eingeschränkt.

In einer weiteren vorteilhaften Ausgestaltung weist der Substratträger an der der Prozesskammerführung zugewandten Seite eine Rollenlagerung auf, so dass ein reibungsarmes Verschieben des Substratträgers in Führungsrichtung der Prozesskammerführung erzielt wird.

In einer vorteilhaften Ausführungsform weist der Substratträger einen Abdichtungssteg auf, welcher sich in Führungsrichtung erstreckt und derart angeordnet ist, dass in Prozessposition der Abdichtungssteg um weniger als 0,3 mm, bevorzugt weniger als 0,2 mm, insbesondere weniger als 0,1 mm von der Prozesskammerführung beabstandet ist.

Vorteilhafterweise ist die vorgenannte Prozesskammerführung als untere Prozesskammerführung der Prozesskammer angeordnet und die Prozesskammer weist weiterhin zusätzlich mindestens eine obere Prozesskammerführung auf, die mit den Stirnabgrenzungselementen verbunden und derart angeordnet ist, dass in Prozessposition der Substratträger zwischen unterer und oberer Prozesskammerführung angeordnet ist. Die obere Prozesskammerführung ist ebenfalls als erfindungsgemäße Prozesskammerführung, insbesondere als vorteilhafte Ausführungsform hiervon ausgebildet. Es ist somit in Prozessposition am oberen und am unteren Rand des Substratträgers eine Abdichtungswirkung durch eine erfindungsgemäße Prozesskammerführung gegeben. Am vorderen und am hinteren Rand erfolgt die Begrenzung der Prozesskammer durch weitere in Führungsrichtung vorangehend und/oder nachfolgend angeordnete Substratträger und/oder durch die Stirnabgrenzungselemente.

In einer vorteilhaften Ausführungsform wird die Prozesskammer zu zwei gegenüberliegenden Seiten durch jeweils einen Substratträger begrenzt:
Vorteilhafterweise weist die Prozesskammer den vorgenannten Substratträger als ersten Substratträger und weiterhin zumindest einen zweiten Substratträger auf. Weiterhin weist die Prozesskammer zusätzlich zu unterer und oberer Prozesskammerführung als erstes Prozesskammerführungspaar zumindest eine weitere untere Prozesskammerführung und eine weitere obere Prozesskammerführung als zweites Prozesskammerführungspaar auf. Die Prozesskammerführungen des zweiten Prozesskammerführungspaars sind ebenfalls als erfindungsgemäße Prozesskammerführungen, insbesondere als vorteilhafte Ausführungsformen hiervon, ausgebildet.

Besonders vorteilhaft ist es, mehrere Prozesskammern nebeneinander liegend auszubilden. Hierzu werden zumindest drei parallel nebeneinander liegende Substratträger verwendet, wobei der mittlere Substratträger beidseitig Substrate zur Bearbeitung, insbesondere zur Beschichtung trägt. Es ist somit eine erste Prozesskammer zwischen linkem und mittlerem Substratträger sowie eine zweite Prozesskammer zwischen mittlerem und rechtem Substratträger ausgebildet. Entsprechend werden die Substratträger durch drei untere und drei obere Prozesskammerführungen geführt.

Vorteilhafterweise weist die Prozesskammerführung zumindest einen Einlass für ein Spülgas auf. Der Einlass ist derart angeordnet, dass in Prozessposition zwischen Prozesskammerführung und Substratträger Spülgas zuführbar ist. Hierdurch ergibt sich der Vorteil, dass eine unerwünschte Ablagerung im Bereich zwischen Prozesskammerführung und Substratträger und insbesondere an der Rollenlagerung vermieden werden kann. Vorzugsweise wird daher während des Prozesses, insbesondere während eines Abscheidevorgangs Spülgas zumindest zeitweise, bevorzugt dauerhaft zugeführt.

Es liegt hierbei im Rahmen der Erfindung, dass Spülgas mit einem Überdruck gegenüber dem in der Prozesskammer herrschenden Druck zugeführt wird, so dass - zumindest geringfügig - Spülgas in die Prozesskammer eindringen kann. Hierdurch wird in besonders effektiver Weise ein Eindringen von Gasen und Partikeln aus der Prozesskammer in den Bereich zwischen Prozesskammerführung und Substratträger und insbesondere zu der Rollenlagerung hin vermieden. Alternativ oder zusätzlich ist es vorteilhaft, eine Spülgasabführung vorzusehen, so dass gleichzeitig Spülgas zu- und abgeführt werden kann, um unerwünschte Gase oder Partikel aus dem Zwischenraum zwischen Prozesskammerführung und Substratträger zu entfernen.

In Prozessposition ist der zweite Substratträger zwischen unterer und oberer Prozesskammerführung des zweiten Prozesskammerführungspaars angeordnet und die Prozesskammer ist somit durch die Substratträger, Prozesskammerführungen und Stirnabgrenzungselemente ausgebildet. Hierbei liegt es im Rahmen der Erfindung, dass sich in Führungsrichtung die Prozesskammer über eine Länge erstreckt, welche größer als die Breite des Substratträgers in Führungsrichtung ist. In diesem Fall erfolgt die seitliche Abgrenzung durch ein Aneinanderreihen mehrerer Substratträger wie vorhergehend beschrieben, in der vorliegenden Ausbildung zu zwei gegenüberliegenden Seiten.

Vorteilhafterweise weisen die unteren Prozesskammerführungen jeweils eine Rollenlagerung für Substratträger auf, hierdurch ist ein Verschieben der Substratträger mit geringem Widerstand möglich.

Insbesondere ist es vorteilhaft, dass die oberen Prozesskammerführungen jeweils eine Rollenlagerung aufweisen, um auch bei den oberen Führungen Reibungskräfte oder nicht-gleichförmige Verschiebungsbewegungen durch wechselseitiges Auftreten von Haft- und Gleitreibung zu vermeiden.

Vorteilhafterweise weist jeder Substratträger jeweils einen Abdichtungssteg wie zuvor beschrieben auf und die Abdichtungsstege sind derart angeordnet, dass in Prozessposition die Abdichtungsstege auf einander zugewandten Seiten der Substratträger liegen. Hierdurch wird eine besonders effiziente Abdichtung erzielt.

Vorteilhafterweise weisen alle Substratträger der Prozesskammer an allen Prozeskammerführungen zugewandten Seiten Rollenlagerungen auf, um ein reibungsarmes Verschieben zu ermöglichen.

Die Erfindung betrifft weiterhin eine Vorrichtung zum chemischen Abscheiden einer Schicht auf ein Substrat, insbesondere ein Saatsubstrat, mit einer erfindungsgemäßen Prozesskammer wie zuvor beschrieben. Eine solche Vorrichtung weist die zuvor genannten Vorteile auf.

Die vorliegende Erfindung ist insbesondere für Prozesse vorteilhaft, bei denen Halbleiterschichten und/oder Barriereschichten auf das Saatsubstrat chemisch abgeschieden werden. Insbesondere vorteilhaft ist die vorliegende Erfindung bei Prozessen, bei denen die abgeschiedene Schicht anschließend wieder von dem Saatsubstrat abgelöst wird, so dass mittels der Erfindung eine eigenständige Schicht, insbesondere eine Halbleiterschicht erzeugt wird. Die abgeschiedene Schicht kann beispielsweise eine Siliziumschicht, eine Silizium enthaltende Schicht wie eine Siliziumnitridschicht oder Siliziumcarbidschicht oder eine III-V-Halbleitschicht wie eine Gallium-Arsenid-Schicht sein.

Die vorliegende Erfindung wird vorteilhaft bei der Herstellung von Halbleiterschichten, insbesondere Siliziumschichten für die Produktion von Halbleiterbauelementen, insbesondere großflächigen Halbleiterbauelementen wie Solarzellen eingesetzt. Ebenso kann die vorliegende Erfindung eingesetzt werden, um bei der Produktion von Halbleiterbauelementen, insbesondere großflächige Halbleiterbauelemente wie Solarzellen, vorhandene Halbleitersubstrate, wie beispielsweise Siliziumwafer zur Solarzellenherstellung, beschichtet werden. Bei solchen Prozessen ist häufig die Beschichtung des Halbleitersubstrates mit einer Barrierenschicht oder mit einer weiteren Halbleiterschicht wünschenswert.

Weitere bevorzugte Merkmale und Ausführungsformen werden im Folgenden anhand von Ausführungsbeispielen und den Figuren beschrieben. Dabei zeigt:
- Figur 1: ein erstes Ausführungsbeispiel einer Prozesskammerführung mit einer Abdichtungsfläche (nicht erfinderisch);
- Figur 2: eine Draufsicht von oben auf die Prozesskammerführung gemäß Figur 1 (nicht erfinderisch);
- Figur 3: ein zweites Ausführungsbeispiel einer Prozesskammerführung mit zwei Abdichtungsflächen;
- Figur 4: ein drittes Ausführungsbeispiel einer Prozesskammerführung mit vier Abdichtungsflächen;
- Figur 5: ein Ausführungsbeispiel einer Prozesskammer zu Gasphasenabscheidung mit insgesamt vier Prozesskammerführungen.

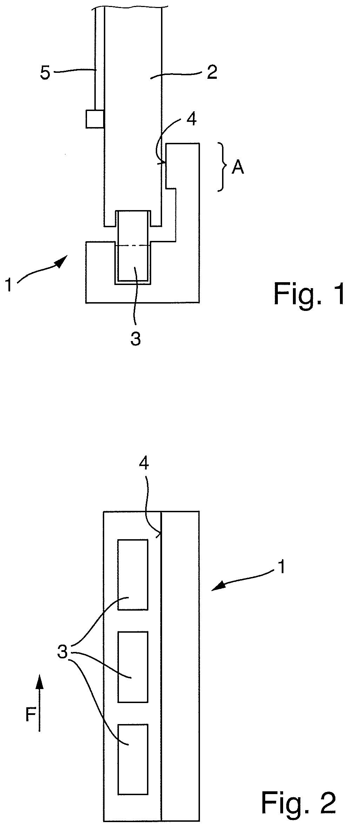

Sämtliche Zeichnungen zeigen schematische, nicht maßstabsgetreue Darstellungen. Gleiche Bezugszeichen in den Figuren 1 bis 5 bezeichnen gleiche oder gleichwirkende Elemente.

In Figur 1 ist ein erstes Ausführungsbeispiel einer Prozesskammerführung 1 dargestellt. Die Prozesskammerführung 1 ist ausgebildet zum geradlinigen Führen eines in der Prozesskammerführung verschiebbaren Substratträgers 2. Der Substratträger 2 ist in der Prozesskammerführung in einer Führungsrichtung verschiebbar. In Figur 1 steht die Führungsrichtung senkrecht zur Zeichenebene und zeigt in diese hinein. Die Prozesskammerführung weist eine Rollenlagerung auf, welche mittels mehrerer drehbar in der Prozesskammerführung gelagerten Rollen ausgebildet ist. In Figur 1 ist eine Rolle 3 ersichtlich. Bei Benutzung liegt der Substratträger auf der Rolle 3 auf und ist hierdurch in Führungsrichtung verschiebbar.

Die Prozesskammerführung 1 weist weiterhin einen Fortsatz mit einer Abdichtungsfläche 4 auf. Die Abdichtungsfläche 4 erstreckt sich parallel zur Führungsrichtung und ist derart ausgebildet und angeordnet, dass in Prozessposition gemäß der Darstellung in Figur 1 bei in der Prozesskammerführung angeordnetem Substratträger 2 die Abdichtungsfläche weniger als 1 mm, vorliegend um 0,2 mm, von dem Substratträger beabstandet ist. Die Abdichtungsfläche 2 erstreckt sich somit ebenfalls parallel zu einer in Figur 1 rechts liegenden Seitenfläche des Substratträgers 2. Zwischen dieser Seitenfläche des Substratträgers 2 und der Abdichtungsfläche 4 besteht wie zuvor beschrieben ein Abstand von 0,2 mm. Senkrecht zur Führungsrichtung erstreckt sich die Abdichtungsfläche über eine Breite A von 20 mm.

Die Länge der Prozesskammerführung in Führungsrichtung ist abhängig von der Vorrichtung, in welcher die Prozesskammerführung eingesetzt werden soll, insbesondere von der gewünschten Länge einer mittels der Prozesskammerführung auszubildenden Prozesskammer. Vorliegend beträgt die Länge der Prozesskammerführung 5 m. In Führungsrichtung erstreckt sich die Abdichtungsfläche 4 über die volle Länge der Prozesskammerführung und weist somit ebenfalls eine Länge von 5 m auf. Eine Prozesskammer wird somit seitlich mittels mehrerer, hintereinander in der Prozesskammerführung angeordneten Substratträgern begrenzt.

Der Substratträger 2 weist auf einer Prozessierungsseite, welche gemäß erstem Ausführungsbeispiel die in Prozessposition der Abdichtungsfläche 4 gegenüberliegende Seite und somit die linke Seite gemäß Figur 1 ist, mehrere Halter für Saatsubstrate (vorliegend Siliziumwafer) auf. Beispielhaft ist ein Saatsubstrat 5 angedeutet.

Während der Benutzung wird in Prozessposition eine Prozesskammer ausgebildet, welche mit weiteren, in Figur 1 nicht dargestellten Komponenten, eine räumliche Umschließung darstellt. Diese räumliche Umschließung wird teilweise durch den Substratträger 2 sowie durch die Prozesskammerführung 1 gebildet.

Ein typischer Prozess für eine solche Vorrichtung ist das Abscheiden einer Halbleiterschicht auf dem Saatsubstrat 5, insbesondere ein als Siliziumwafer mit porosifizierter Oberfläche ausgebildetes Saatsubstrat, insbesondere eine epitaktische Abscheidung. Hierbei soll ein Gasaustausch zwischen Prozesskammer (linke Seite des Substratträgers 2) und Außenbereich (rechte Seite des Substratträgers 2) vermieden werden.

Mittels der Abdichtungsfläche 4 ist nun einerseits gewährleistet, dass kein direkter mechanischer Kontakt zwischen Abdichtungsfläche 4 und Substratträger 2 besteht und somit ein Verschieben des Substratträgers 2 mittels der Rollenlagerung mit nur geringem Widerstand möglich ist. Dennoch bildet der schmale Spalt zwischen Abdichtungsfläche 4 und der der Abdichtungsfläche 4 zugewandten rechten Seite des Substratträgers 2 einen erheblichen Fluidwiderstand aus, sodass ein Gasstrom durch diesen Spalt hindurch vermieden oder zumindest erheblich verringert wird.

In Figur 2 ist eine Draufsicht von oben auf die Prozesskammerführung gemäß Figur 1 dargestellt. Hierbei ist ersichtlich, dass in Führungsrichtung F hintereinander mehrere Rollen 3 angeordnet sind. Alle Rollen der Rollenlagerung sind drehbar in der Prozesskammerführung gelagert. Aus Gründen der besseren Übersicht sind lediglich drei Rollen dargestellt. Tatsächlich kann eine Prozesskammerführung eine erheblich größere Anzahl von Rollen aufweisen, beispielhaft bei der hier genannten Länge von 5 m insgesamt 200 Rollen.

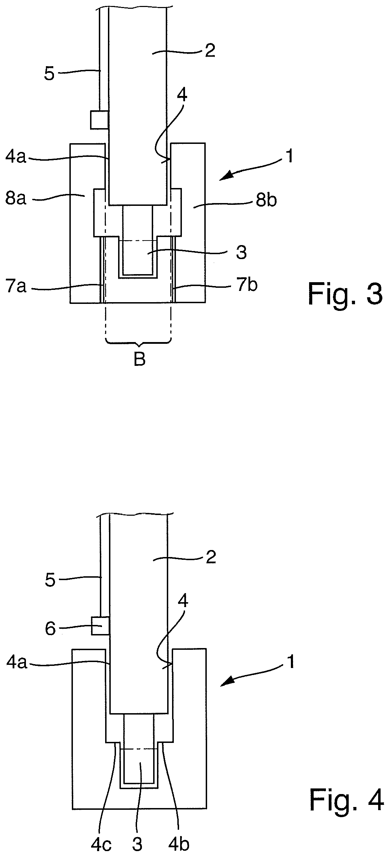

In Figur 3 ist ein zweites Ausführungsbeispiel einer erfindungsgemäßen Prozesskammerführung dargestellt, welches im Grundaufbau dem ersten Ausführungsbeispiel gleicht. Zur Vermeidung von Wiederholungen werden im Folgenden lediglich die wesentlichen Unterschiede beschrieben:

Die Prozesskammerführung gemäß Figur 3 weist zusätzlich zu der genannten Abdichtungsfläche 4 als erste Abdichtungsfläche eine zweite Abdichtungsfläche 4a auf. Die zweite Abdichtungsfläche 4a erstreckt sich ebenfalls parallel zu der Führungsrichtung und ist derart ausgebildet und angeordnet, dass in Prozessposition bei in der Prozesskammerführung angeordnetem Substratträger 2 der Substratträger zwischen den beiden Abdichtungsflächen 4 und 4a angeordnet ist. Die Abdichtungsflächen 4 und 4a weisen senkrecht zur Führungsrichtung einen Abstand B auf, der die Breite des Substratträgers um weniger als 0,4 mm, vorwiegend um etwa 0,2 mm übersteigt. Bei mittig angeordnetem Substratträger 2 besteht somit auf jeder Seite ein Spalt von 0,1 mm zu einer der beiden Abdichtungsflächen 4 und 4a.

Die zweite Abdichtungsfläche 4a ist parallel zur Abdichtungsfläche 4 und mit gleichen Maßen ausgebildet.

Die Prozesskammerführung gemäß Figur 3 weist somit den Vorteil auf, dass ein höherer Fluidwiderstand für einen Gasfluss ausgehend von der linken Seite des Substratträgers 2 zur rechten Seite des Substratträgers 2 oder umgekehrt vorliegt, da beidseitig des Substratträgers ein Fluidstromwiderstand mittels der Abdichtungsfläche 4 einerseits und der Abdichtungsfläche 4a andererseits ausgebildet ist.

Darüber hinaus bietet dieses Ausführungsbeispiel den Vorteil, dass die Abdichtungsflächen 4 und 4a als Führung für den Substratträger 2 gegenüber einem seitlichen Verschieben, das heißt waagrecht in Figur 3, dienen:
In Figur 1 weist der dargestellte Substratträger 2 an der unteren Stirnseite eine Nut auf, in welche die Rolle 3 eingreift. Hierdurch wird ein seitliches Verschieben (waagrecht in Figur 1 und somit senkrecht zur Führungsrichtung) vermieden, da die Seitenwände der Nut des Substratträgers 2 durch einen Kontakt mit den Seitenwänden der Rolle 3 ein seitliches Verschieben vermeiden oder zumindest begrenzen.

In dem Ausführungsbeispiel gemäß Figur 3 ist eine solche Nut des Substratträgers nicht zwingend notwendig, da ein seitliches Verschieben des Substratträgers nach rechts und links durch die Abdichtungsflächen 4 und 4a begrenzt wird. In einem alternativen, vorteilhaften Ausführungsbeispiel wird die Prozesskammerführung gemäß Figur 3 dennoch mit einem Substratträger 2 mit einer Nut gemäß der Darstellung in Figur 1 verwendet, um einen Kontakt des Substratträgers mit den Abdichtungsflächen 4 und 4a zu vermeiden, damit keine Erhöhung des Widerstandes beim Verschieben des Substratträgers erfolgt.

Die Prozesskammerführung 1 gemäß Figur 3 weist weiterhin zwei Einlässe 7a und 7b für Spülgas auf, welche mit entsprechenden Spülgaszuführleitungen verbunden werden können. Im Betriebszustand wird über die Einlässe 7a,7b Spülgas in die Zwischenräume 8a und 8b zwischen Prozesskammerführung 1 und Substratträger 2 zugeführt, so dass in den Zwischenräumen 8a und 8b ein Überdruck gegenüber dem in der Prozesskammer und dem in der Atmosphäre herrschenden Druck vorliegt. Hierdurch wird erzielt, dass an den Abdichtungsflächen 4 und 4a im Wesentlichen geringfügig Spülgas in die Atmosphäre bzw. in die Prozesskammer eindringt. Hierdurch wird in besonders effektiver Weise vermieden, dass Fremdpartikel und unerwünschte Gase in die Zwischenräume 8a und 8b eindringen und insbesondere die Funktion der Rollenlagerung beeinträchtigen. Alternativ oder zusätzlich ist es möglich, stirnseitig am Anfang und/oder Ende, bevorzugt sowohl am Anfang, als auch am Ende der Prozesskammerführung Einlässe für Spülgas vorzusehen.

In Figur 4 ist ein drittes Ausführungsbeispiel einer Prozesskammerführung dargestellt. Auch hier gleicht der Aufbau im Wesentlichen dem Aufbau gemäß Figur 3 und im Folgenden wird zur Vermeidung von Wiederholungen lediglich auf die wesentlichen Unterschiede eingegangen:
Die Prozesskammerführung gemäß Figur 4 weist eine Nut zur Aufnahme des Substratträgers 2 auf. Die Nut ist als rechteckige Nut ausgebildet, wobei an der Bodenfläche der Nut die Rollenlagerung mit Rolle 3 angeordnet ist. Die Prozesskammerführung ist derart ausgebildet, dass im Zusammenwirken mit dem Substratträger 2, der Abstand zwischen den seitlichen Flächen 4 und 4a sowie zwischen den Bodenflächen 4b und 4c der Nut und der jeweils zugewandten Seite des Substratträgers < 0,2 mm ist, vorliegend 0,1 mm. Hierdurch wird somit durch vier Abdichtungsflächen 4, 4a, 4b und 4c ein Fluidwiderstand ausgebildet, welcher einen Gasfluss von der linken Seite des Substratträgers 2 zu der rechten Seite des Substratträgers 2 oder umgekehrt vermeidet oder zumindest erheblich verringert.

Zusätzlich weist der Saatsubstraträger 2 gemäß Figur 4 einen Abdichtungssteg 6 auf. Dieser Abdichtungssteg 6 dient gleichzeitig als untere Halteleiste für Saatsubstrate 5. Der Abdichtungssteg 6 erstreckt sich in Führungsrichtung (in die Zeichenebene hinein) und ist derart angeordnet, dass in der dargestellten Prozessposition der Abdichtungssteg um weniger als 0,5 mm, vorliegend um etwa 0,2 mm von der Prozesskammerführung beabstandet ist. Hierdurch wird zusätzlich eine Erhöhung des Strömungswiderstandes für Gasströme in die Nut hinein oder aus der Nut heraus erzielt.

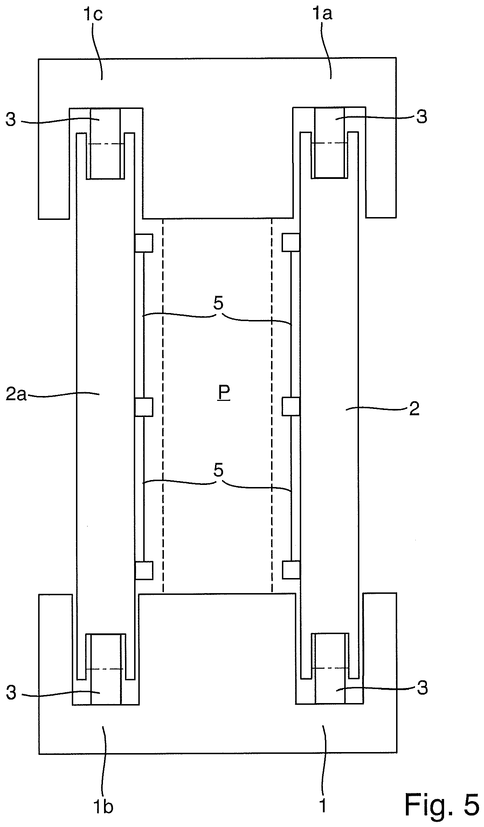

Vorteilhafterweise sind jeweils zwei Prozesskammerführungen einstückig ausgebildet. Dies wird an dem Ausführungsbeispiel einer erfindungsgemäßen Prozesskammer und der Darstellung gemäß Figur 5 näher erläutert:
In Figur 5 ist ein Ausführungsbeispiel einer erfindungsgemäßen Prozesskammer dargestellt. Die Prozesskammer weist eine untere Prozesskammerführung 1 und eine obere Prozesskammerführung 1a als erstes Prozesskammerführungspaar auf. Weiterhin weist die Prozesskammer eine weitere untere Prozesskammerführung 1b und eine weitere Prozesskammerführung 1c als zweites Prozesskammerführungspaar auf. Die unteren Prozesskammerführungen 1 und 1b sind einstückig ausgebildet. Ebenso sind die oberen Prozesskammerführungen 1a und 1c einstückig ausgebildet. Die Prozesskammer weist zusätzlich zwei Substratträger 2 und 2a auf, die jeweils Halterungen für Saatsubstrate 5 aufweisen.

Die Prozesskammerführungen 1, 1a, 1b und 1c sind gemäß der in Figur 4 dargestellten Prozesskammerführung ausgebildet und weisen somit jeweils eine Nut zur Aufnahme des Substratträgers auf. In der in Figur 5 dargestellten Prozessposition sind die Substratträger derart angeordnet, dass die Saatsubstrate einander gegenüberliegen. Es ist somit eine Prozesskammer P ausgebildet, welche seitlich durch die Substratträger 2 und 2a (bzw. durch die darauf angeordnete Saatsubstrate 5) begrenzt wird. Nach oben und unten wird die Prozesskammer durch die Prozesskammerführungen 1, 1a, 1b und 1c begrenzt. Stirnseitig weist die Prozesskammer jeweils ein Stirnabgrenzungselement auf, welches mit den Prozesskammerführungen fluiddicht verbunden ist. Die Ausdehnung des Stirnabgrenzungselementes ist durch gestrichelte Linien in Figur 5 dargestellt. Die Stirnabgrenzungselemente sind somit derart ausgebildet, dass stirnseitig ein Gasfluss aus der Prozesskammer P heraus vermieden oder zumindest verringert wird, ein Verschieben der Substratträger 2 und 2a in Führungsrichtung an den Stirnabgrenzungselementen vorbei jedoch möglich ist. Die Stirnabgrenzungselemente sind am Anfang und Ende der Prozesskammerführungen angeordnet, welche jeweils eine Länge von 5 m aufweisen. Der Abstand der Stirnabgrenzungselemente, welche parallel zueinander angeordnet sind, beträgt somit ebenfalls etwa 5 mm.

Im Unterschied zu den zuvor beschriebenen Ausführungsbeispielen sind dem Ausführungsbeispiel gemäß Figur 5 die Rollen 3 jeweils an den Substratträgern angeordnet und laufen in Nuten, welche in den Prozesskammerführungen ausgebildet sind. In diesem Ausführungsbeispiel sind die Rollenlagerungen somit an den Substratträgern angeordnet.

Hierdurch ist somit eine Prozesskammer P ausgebildet, welche in Führungsrichtung eine Länge von etwa 5 mm aufweist und eine Breite aufweist, welche etwa dem Abstand der einander zugewandten Flächen der Substratträger 2 und 2a entspricht, vorliegend etwa 10 cm. Die Höhe der Prozesskammer entspricht dem Abstand der unteren Prozesskammerführungen zu den oberen Prozesskammerführungen, vorliegend etwa 40 cm.

In einem weiteren Ausführungsbeispiel wird die Prozesskammer gemäß Figur 5 um einen weiteren Saatsubstratträger erweitert, welcher rechts neben dem Saatsubstratträger 2 angeordnet ist. Entsprechend werden auch für den dritten Saatsubstratträger obere und untere Prozesskammerführungen jeweils mit Nuten für Rollen vorgesehen. Hierdurch ist neben der in Figur 5 dargestellten Prozesskammer P eine zweite Prozesskammer zwischen Saatsubstratträger 2 und dem dritten Saatsubstratträger ausgebildet. Entsprechend weist der Saatsubstratträger 2 in diesem Ausführungsbeispiel sowohl an der linken, als auch an der rechten Seite Substrate zum Bearbeiten auf. Der dritte Substratträger weist entsprechend lediglich an der linken Seite, welche der zweiten Prozesskammer zugeordnet ist, Substrate zum Bearbeiten auf.

## Patentansprüche

1. Prozesskammer (P) zur Gasphasenabscheidung von Siliziumschichten, mit zumindest einer Prozesskammerführung (1, 1a, 1b, 1c) und zumindest einem Substratträger (2, 2a), wobei die Prozesskammerführung (1, 1a, 1b, 1c) zum geradlinigen Führen des in der Prozesskammerführung (1, 1a, 1b, 1c) verschiebbaren Substratträgers (2, 2a) in einer Führungsrichtung ausgebildet ist, so dass mittels Verschieben des Substratträgers (2, 2a) in eine Prozessposition eine zumindest bereichsweise Abgrenzung der Prozesskammer (P) durch Prozesskammerführung (1, 1a, 1b, 1c) und Substratträger (2, 2a) ausbildbar ist,
**dadurch gekennzeichnet,**
**dass** zumindest eine Abdichtungsfläche (4, 4a), welche sich parallel zu der Führungsrichtung erstreckt und derart ausgebildet und angeordnet ist, dass bei in der Prozesskammerführung (1, 1a, 1b, 1c) angeordnetem Substratträger (2, 2a) in Prozessposition die Abdichtungsfläche (4, 4a) zumindest 0,02 mm und weniger als 1 mm von dem Substratträger (2, 2a) beabstandet ist und dass der Substratträger (2, 2a) einen Abdichtungssteg (6) aufweist, welcher sich in Führungsrichtung erstreckt und derart angeordnet ist, dass in Prozessposition der Abdichtungssteg (6) um weniger als 0,5 mm von der Prozesskammerführung (1, 1a, 1b, 1c) beabstandet ist.

2. Prozesskammer (P) nach Anspruch 1,
**dadurch gekennzeichnet,**
**dass** die Abdichtungsfläche (4, 4a) senkrecht zur Führungsrichtung und parallel zur Oberfläche des in der Prozesskammerführung (1, 1a, 1b, 1c) angeordneten Substratträgers (2, 2a) eine Breite von zumindest 2 mm, insbesondere zumindest 10 mm, bevorzugt zumindest 20 mm aufweist.

3. Prozesskammer (P) nach einem der vorangegangenen Ansprüche,
**dadurch gekennzeichnet,**
**dass** die Prozesskammerführung (1, 1a, 1b, 1c) zusätzlich zu der genannten ersten Abdichtungsfläche (4, 4a) zumindest eine zweite Abdichtungsfläche (4, 4a) aufweist, welche sich parallel zu der Führungsrichtung erstreckt und derart ausgebildet und angeordnet ist, dass bei einem in der Prozesskammerführung (1, 1a, 1b, 1c) angeordneten Substratträger (2, 2a) in Prozessposition der Substratträger (2, 2a) zwischen den beiden Abdichtungsflächen angeordnet ist und
die Abdichtungsflächen senkrecht zur Führungsrichtung einen Abstand aufweisen, der die Breite des Substratträgers (2, 2a) um weniger als 0,4 mm, bevorzugt um weniger als 0,3 mm, insbesondere um weniger als 0,2 mm übersteigt.

4. Prozesskammer (P) nach einem der vorangegangenen Ansprüche,
**dadurch gekennzeichnet,**
**dass** die Prozesskammerführung (1, 1a, 1b, 1c) eine Rollenlagerung für den Substratträger (2, 2a) aufweist.

5. Prozesskammer (P) nach einem der vorangegangenen Ansprüche,
**dadurch gekennzeichnet,**
**dass** die Prozesskammerführung (1, 1a, 1b, 1c) eine Nut zur Aufnahme des Substratträgers (2, 2a) aufweist, insbesondere eine rechteckige Nut.

6. Prozesskammer (P) nach den Ansprüchen 4 und 5,
**dadurch gekennzeichnet,**
**dass** die Rollenlagerung an der Bodenfläche der Nut angeordnet ist.

7. Prozesskammer (P) nach einem der Ansprüche 5 bis 6,
**dadurch gekennzeichnet,**
**dass** eine der Seitenflächen der Nut, bevorzugt beide Seitenflächen der Nut zumindest in Teilbereichen als Abdichtungsfläche (4, 4a) ausgebildet sind.

8. Prozesskammer (P) nach einem der vorhergehenden Ansprüche **dadurch gekennzeichnet , dass** die Prozesskammer (P) an zwei gegenüberliegenden Seiten Stirnabgrenzungselemente aufweist, welche mit der Prozesskammerführung (1, 1a, 1b, 1c) verbunden sind, insbesondere, dass der Substratträger (2, 2a) eine Führung für Rollen (3) der Rollenlagerung aufweist, insbesondere eine Nut oder
dass der Substratträger (2, 2a) eine Rollenlagerung aufweist, welche an der der Prozesskammerführung (1, 1a, 1b, 1c) zugewandten Seite des Substratträgers (2, 2a) angeordnet ist.

9. Prozesskammer (P) nach einem der vorhergehenden Ansprüche,
**dadurch gekennzeichnet,**
**dass** in Prozessposition der Abdichtungssteg (6) um weniger als 0,3 mm, insbesondere um weniger als 0,2 mm von der Prozesskammerführung (1, 1a, 1b, 1c) beabstandet ist.

10. Prozesskammer (P) nach einem der vorhergehenden Ansprüche,
**dadurch gekennzeichnet,**
**dass** die Prozesskammer (P) die Prozesskammerführung (1, 1a, 1b, 1c) als untere Prozesskammerführung (1, 1a, 1b, 1c) und zusätzlich zumindest eine obere Prozesskammerführung (1, 1a, 1b, 1c) aufweist, die mit den Stirnabgrenzungselementen verbunden und derart angeordnet ist, dass in Prozessposition der Substratträger (2, 2a) zwischen unterer und oberer Prozesskammerführung (1, 1a, 1b, 1c) angeordnet ist.

11. Prozesskammer (P) nach Anspruch 10,
**dadurch gekennzeichnet,**
**dass** die Prozesskammer (P) zusätzlich zu dem Substratträger (2, 2a) als ersten Substratträger (2, 2a) zumindest einen zweiten Substratträger (2, 2a) aufweist und zusätzlich zu unterer und oberer Prozesskammerführung (1, 1a, 1b, 1c) als erstes Prozesskammerführungspaar zumindest eine weitere untere Prozesskammerführung (1, 1a, 1b, 1c) und eine weitere obere Prozesskammerführung (1, 1a, 1b, 1c) als zweites Prozesskammerführungspaar aufweist, welche derart ausgebildet und angeordnet sind,
**dass** in Prozessposition der zweite Substratträger (2, 2a) zwischen unterer und oberer Prozesskammerführung (1, 1a, 1b, 1c) des zweiten Prozesskammerführungspaars angeordnet ist und die Prozesskammer (P) durch die Substratträger (2, 2a), Prozesskammerführungen (1, 1a, 1b, 1c) und Stirnabgrenzungselemente ausgebildet ist.

12. Prozesskammer (P) nach Anspruch 11,
**dadurch gekennzeichnet,**
**dass** die unteren Prozesskammerführungen (1, 1a, 1b, 1c) jeweils eine Rollenlagerung für Substratträger (2, 2a) aufweisen und/oder dass Substratträger (2, 2a) jeweils an den den unteren Prozesskammerführungen (1, 1a, 1b, 1c) zugewandten Seiten Rollenlagerungen aufweisen und/oder dass die oberen Prozesskammerführungen (1, 1a, 1b, 1c) jeweils eine Rollenlagerung aufweisen und/oder dass Substratträger (2, 2a) jeweils an den den oberen Prozesskammerführungen (1, 1a, 1b, 1c) zugewandten Seiten Rollenlagerungen aufweisen.

13. Prozesskammer (P) nach einem der Ansprüche 10 bis 12,
**dadurch gekennzeichnet,**
**dass** jeder Substratträger (2, 2a) jeweils einen Abdichtungssteg (6) aufweist und die Abdichtungsstege (6) derart angeordnet sind, dass in Prozessposition die Abdichtungsstege (6) auf einander zugewandten Seiten der Substratträger (2, 2a) liegen und/oder
**dass** die Prozesskammerführung (1, 1a, 1b, 1c) mindestens einen Einlass (7a, 7b) für ein Spülgas aufweist, welcher derart angeordnet ist, dass in Prozessposition Spülgas zwischen Prozesskammerführung (1, 1a, 1b, 1c) und Substratträger (2, 2a) einführbar ist, bevorzugt zwischen Prozesskammerführung (1, 1a, 1b, 1c) und der der Prozesskammerführung (1, 1a, 1b, 1c) zugewandten Stirnseite des Substratträgers (2) einführbar ist.

14. Vorrichtung zum chemischen Abscheiden einer Siliziumschicht auf ein Substrat,
mit einer Prozesskammer (P) nach einem der Ansprüche 1 bis 13.

15. Verfahren zum Führen eines Substratträgers (2, 2a) in eine Prozessposition, **dadurch gekennzeichnet,**
**dass** der Substratträger (2, 2a) in einer Prozesskammerführung (1, 1a, 1b, 1c) einer Prozesskammer (P) nach einem der Ansprüche 1 bis 13 mittels eines Rollenlagers geführt wird,
insbesondere, dass zwischen Substratträger (2, 2a) und Prozesskammerführung (1, 1a, 1b, 1c), bevorzugt zwischen einer der Prozesskammerführung (1, 1a, 1b, 1c) zugewandten Stirnseite des Substratträgers (2, 2a) und der Prozesskammerführung (1, 1a, 1b, 1c) ein Spülgas zugeführt wird, bevorzugt während eines Abscheideprzessses.

## Claims

1. Process chamber (P) for the gas phase deposition of silicon layers, having at least one process chamber guide (1, 1a, 1b, 1c) and at least one substrate carrier (2, 2a), wherein the process chamber guide (1, 1a, 1b, 1c) is configured to guide in straight lines in a guiding direction the substrate carrier (2, 2a) which is displaceable in the process chamber guide (1, 1a, 1b, 1c), such that by means of displacing the substrate carrier (2, 2a) into a process position an at least partial delimiting of the process chamber (P) by means of process chamber guide (1, 1a, 1b, 1c) and substrate carrier (2, 2a) can be formed,
**characterised in that**
at least one sealing surface (4, 4a) extends parallel to the guiding direction and is formed and arranged such that when the substrate carrier (2, 2a) arranged in the process chamber guide (1, 1a, 1b, 1c) is in process position, the sealing surface (4, 4a) is spaced at least 0.02 mm and less than 1 mm from the substrate carrier (2, 2a) and that the substrate carrier (2, 2a) has a sealing web (6) which extends in guiding direction and is arranged such that in process position the sealing web (6) is spaced from the process chamber guide (1, 1a, 1b, 1c) by less than 0.5 mm.

2. Process chamber (P) according to claim 1,
**characterised in that**
the sealing surface (4, 4a) perpendicular to the guiding direction and parallel to the surface of the substrate carrier (2, 2a) arranged in the process chamber guide (1, 1a, 1b, 1c) has a breadth of at least 2 mm, in particular at least 10 mm, preferably at least 20 mm.

3. Process chamber (P) according to any of the preceding claims,
**characterised in that**
the process chamber guide (1, 1a, 1b, 1c) has, in addition to the mentioned first sealing surface (4, 4a), at least one second sealing surface (4, 4a) which extends parallel to the guiding direction and is formed and arranged such that when a substrate carrier (2, 2a) arranged in the process chamber guide (1, 1a, 1b, 1c) is in process position, the substrate carrier (2, 2a) is arranged between the two sealing surfaces and
the sealing surfaces have, perpendicular to the guiding direction, a spacing which exceeds the breadth of the substrate carrier (2, 2a) by less than 0.4 mm, preferably by less than 0.3 mm, in particular by less than 0.2 mm.

4. Process chamber (P) according to any of the preceding claims,
**characterised in that**
the process chamber guide (1, 1a, 1b, 1c) has a roller bearing support for the substrate carrier (2, 2a).

5. Process chamber (P) according to any of the preceding claims,
**characterised in that**
the process chamber guide (1, 1a, 1b, 1c) has a groove for receiving the substrate carrier (2, 2a), in particular a rectangular groove.

6. Process chamber (P) according to claims 4 and 5,
**characterised in that**
the roller bearing support is arranged on the floor surface of the groove.

7. Process chamber (P) according to any of claims 5 to 6,
**characterised in that**
one of the side surfaces of the groove, preferably both side surfaces of the groove, are formed as a sealing surface (4, 4a) at least in partial regions.

8. Process chamber (P) according to any of the preceding claims, **characterised in that** the process chamber (P) has front demarcation elements on two oppositely-situated sides which are connected to the process chamber guide (1, 1a, 1b, 1c), in particular that the substrate carrier (2, 2a) has a guide for rollers (3) of the roller bearing support, in particular a groove or that the substrate carrier (2, 2a) has a roller bearing support which is arranged on the side of the substrate carrier (2, 2a) facing the process chamber guide (1, 1a, 1b, 1c).

9. Process chamber (P) according to any of the preceding claims,
**characterised in that**
in process position the sealing web (6) is spaced from the process chamber guide (1, 1a, 1b, 1c) by less than 0.3 mm, in particular by less than 0.2 mm.

10. Process chamber (P) according to any of the preceding claims,
**characterised in that**
the process chamber (P) has the process chamber guide (1, 1a, 1b, 1c) as a lower process chamber guide (1, 1a, 1b, 1c) and in addition at least one upper process chamber guide (1, 1a, 1b, 1c) which is connected to the front demarcation elements and is arranged such that in process position the substrate carrier (2, 2a) is arranged between lower and upper process chamber guides (1, 1a, 1b, 1c).

11. Process chamber (P) according to claim 10,
**characterised in that**
the process chamber (P) has in addition to the substrate carrier (2, 2a) as first substrate carrier (2, 2a) at least one second substrate carrier (2, 2a) and in addition to a lower and upper process chamber guide (1, 1a, 1b, 1c) as first process chamber guide pair at least one further lower process chamber guide (1, 1a, 1b, 1c) and one further upper process chamber guide (1, 1a, 1b, 1c) as a second process chamber guide pair which are formed and arranged such
that in the process position the second substrate carrier (2, 2a) is arranged between the lower and upper process chamber guides (1, 1a, 1b, 1c) of the second process chamber guide pair and the process chamber (P) is formed by the substrate carrier (2, 2a), process chamber guides (1, 1a, 1b, 1c) and front demarcation elements.

12. Process chamber (P) according to claim 11,
**characterised in that**
the lower process chamber guides (1, 1a, 1b, 1c) have respectively one roller bearing support for substrate carriers (2, 2a) and/or that substrate carriers (2, 2a) have roller bearing supports respectively on the sides facing the lower process chamber guides (1, 1a, 1b, 1c) and/or that the upper process chamber guides (1, 1a, 1b, 1c) have respectively one roller bearing support and/or that substrate carriers (2, 2a) have roller bearing supports respectively on the sides facing the upper process chamber guides (1, 1a, 1b, 1c).

13. Process chamber (P) according to any of claims 10 to 12,
**characterised in that**
each substrate carrier (2, 2a) has respectively one sealing web (6) and the sealing webs (6) are arranged such that in process position the sealing webs (6) are situated on sides of the substrate carriers (2, 2a) facing one another and/or
that the process chamber guide (1, 1a, 1b, 1c) has at least one inlet (7a, 7b) for a rinsing gas, which is arranged such that in process position rinsing gas can be introduced between process chamber guide (1, 1a, 1b, 1c) and substrate carrier (2, 2a), preferably can be introduced between process chamber guide (1, 1a, 1b, 1c) and the end face of the substrate carrier (2) facing the process chamber guide (1, 1a, 1b, 1c),

14. Device for the chemical deposition of a silicon layer onto a substrate,
having a process chamber (P) according to any of claims 1 to 13.

15. Method for guiding a substrate carrier (2, 2a) into a process position,
**characterised in that**
the substrate carrier (2, 2a) is guided in a process chamber guide (1, 1a, 1b, 1c) of a process chamber (P) according to any of claims 1 to 13 by means of a roller bearing support,
in particular, that a rinsing gas is supplied between substrate carrier (2, 2a) and process chamber guide (1, 1a, 1b, 1c), preferably between an end face of the substrate carrier (2, 2a) facing the process chamber guide (1, 1a, 1b, 1c) and the process chamber guide (1, 1a, 1b, 1c), preferably during a deposition process.

## Revendications

1. Chambre de traitement (P) destinée au dépôt en phase vapeur de couches de silicium, avec au moins un guidage de chambre de traitement (1, 1a, 1b, 1c) et au moins un support de substrat (2, 2a), dans laquelle le guidage de chambre de traitement (1, 1a, 1b, 1c) est conçu pour guider de manière rectiligne dans une direction de guidage le support de substrat (2, 2a) pouvant être déplacé dans le guidage de chambre de traitement (2, 2a) de sorte qu'une délimitation au moins par zones de la chambre de traitement (P) peut être formée par un guidage de chambre de traitement (1, 1a, 1b, 1c) et un support de substrat (2, 2a) au moyen du déplacement du support de substrat (2, 2a),
**caractérisée en ce que**
au moins une surface d'étanchéité (4, 4a), laquelle s'étend parallèlement à la direction de guidage et est formée et disposée de telle sorte que, pour le support de substrat (2, 2a) disposé dans le guidage de chambre de traitement (1, 1a, 1b, 1c) dans une position de traitement, la surface d'étanchéité (4, 4a) est espacée d'au moins 0,02 mm et de moins de 1 mm du support de substrat (2, 2a) et **en ce que** le support de substrat (2, 2a) présente une barrette d'étanchéité (6), laquelle s'étend dans une direction de guidage et est disposée de telle sorte que, dans la position de traitement, la barrette d'étanchéité (6) est espacée de moins de 0,5 mm du guidage de chambre de traitement (1, 1a, 1b, 1c).

2. Chambre de traitement (P) selon la revendication 1,
**caractérisée en ce que**
la surface d'étanchéité (4, 4a) perpendiculaire à la direction de guidage et parallèle à la surface du support de substrat (2, 2a) disposé dans le guidage de chambre de traitement (1, 1a, 1b, 1c) présente une largeur d'au moins 2 mm, en particulier d'au moins 10 mm, de préférence d'au moins 20 mm.

3. Chambre de traitement (P) selon l'une quelconque des revendications précédentes,
**caractérisée en ce que**
le guidage de chambre de traitement (1, 1a, 1b, 1c), en plus de la ladite première surface d'étanchéité (4, 4a), présente au moins une seconde surface d'étanchéité (4, 4a), laquelle s'étend parallèlement à la direction de guidage, et est formée et disposée de telle sorte que, pour un support de substrat (2, 2a) disposé dans le guidage de chambre de traitement (1, 1a, 1b, 1c) dans une position de traitement, le support de substrat (2, 2a) est disposé entre les deux surfaces d'étanchéité et
les surfaces d'étanchéité perpendiculaires à la direction de guidage présentent une distance, qui dépasse la largeur du support de substrat (2, 2a) de moins de 0,4 mm, de préférence de moins de 0,3 mm, en particulier de moins de 0,2 mm.

4. Chambre de traitement (P) selon l'une quelconque des revendications précédentes,
**caractérisée en ce que**
le guidage de chambre de traitement (1, 1a, 1b, 1c) présente un roulement à rouleaux pour le support de substrat (2, 2a).

5. Chambre de traitement (P) selon l'une quelconque des revendications précédentes,
**caractérisée en ce que**
le guidage de chambre de traitement (1, 1a, 1b, 1c) présente une rainure pour la réception du support de substrat (2, 2a), en particulier une rainure rectangulaire.

6. Chambre de traitement (P) selon les revendications 4 et 5,
**caractérisée en ce que**
le roulement à rouleaux est disposé sur la surface de base de la rainure.

7. Chambre de traitement (P) selon l'une quelconque des revendications 5 à 6,
**caractérisée en ce que**
une des surfaces latérales de la rainure, de préférence les deux surfaces latérales de la rainure sont formées au moins dans des zones partielles comme surface d'étanchéité (4, 4a).

8. Chambre de traitement (P) selon l'une quelconque des revendications précédentes, **caractérisée en ce que** la chambre de traitement (P) présente sur deux côtés opposés des éléments de délimitation avant, lesquels sont reliés au guidage de chambre de traitement (1, 1a, 1b, 1c), en particulier, **en ce que** le support de substrat (2, 2a) présente un guidage pour rouleaux (3) du roulement à rouleaux, en particulier une rainure ou **en ce que** le support de substrat (2, 2a) présente un roulement à rouleaux, lequel est disposé sur le côté tourné vers le guidage de chambre de traitement (1, 1a, 1b, 1c) du support de substrat (2, 2a).

9. Chambre de traitement (P) selon l'une quelconque des revendications précédentes,
**caractérisée en ce que**
dans une position de traitement la barrette d'étanchéité (6) est espacée de moins de 0,3 mm, en particulier de moins de 0,2 mm du guidage de chambre de traitement (1, 1a, 1b, 1c).

10. Chambre de traitement (P) selon l'une quelconque des revendications précédentes,
**caractérisée en ce que**
la chambre de traitement (P) présente le guidage de chambre de traitement (1, 1a, 1b, 1c) comme guidage de chambre de traitement (1, 1a, 1b, 1c) inférieur et en plus au moins un guidage de chambre de traitement (1, 1a, 1b, 1c) supérieur, qui est relié aux éléments de délimitation avant et disposé de telle sorte que, dans la position de traitement, le support de substrat (2, 2a) est disposé entre le guidage de chambre de traitement (1, 1a, 1b, 1c) inférieur et supérieur.

11. Chambre de traitement (P) selon la revendication 10,
**caractérisée en ce que**
la chambre de traitement (P), en plus du support de substrat (2, 2a), présente comme premier support de substrat (2, 2a) au moins un second support de substrat (2, 2a) e,t en plus du guidage de chambre de traitement (1, 1a, 1b, 1c) inférieur et supérieur, présente comme première paire de guidage de chambre de traitement au moins un autre guidage de chambre de traitement (1, 1a, 1b, 1c) inférieur et un autre guidage de chambre de traitement (1, 1a, 1b, 1c) supérieur comme seconde paire de guidage de chambre de traitement, lesquelles sont formées et disposées de telle sorte que
dans la position de traitement, le second support de substrat (2, 2a) est disposé entre le guidage de chambre de traitement (1, 1a, 1b, 1c) inférieur et supérieur de la seconde paire de guidage de chambre de traitement et la chambre de traitement (P) est formée par le support de substrat (2, 2a), des guidages de chambre de traitement (1, 1a, 1b, 1c) et des éléments de délimitation avant.

12. Chambre de traitement (P) selon la revendication 11,
**caractérisée en ce que**
les guidages de chambre de traitement (1, 1a, 1b, 1c) inférieurs présentent respectivement un roulement à rouleaux pour des supports de substrat (2, 2a) et/ou **en ce que** des supports de substrat (2, 2a) présentent respectivement sur les côtés tournés vers les guidages de chambre de traitement (1, 1a, 1b, 1c) inférieurs des roulements à rouleaux et/ou **en ce que** les guidages de chambre de traitement (1, 1a, 1b, 1c) supérieurs présentent respectivement un roulement à rouleaux et/ou **en ce que** les supports de substrat (2, 2a) présentent respectivement sur les côtés tournés vers les guidages de chambre de traitement (1, 1a, 1b, 1c) supérieurs des roulements à rouleaux.

13. Chambre de traitement (P) selon l'une quelconque des revendications 10 à 12,
**caractérisée en ce que**
chaque support de substrat (2, 2a) présente respectivement une barrette d'étanchéité (6) et les barrettes d'étanchéité (6) sont disposées de telle sorte que, dans une position de traitement, les barrettes d'étanchéité (6) se trouvent sur des côtés opposés des supports de substrat (2, 2a) et/ou
**en ce que** le guidage de chambre de traitement (1, 1a, 1b, 1c) présente au moins une entrée (7a, 7b) pour un gaz de purge, laquelle est disposée de telle sorte que, dans une position de traitement, du gaz de purge peut être introduit entre le guidage de chambre de traitement (1, 1a, 1b, 1c) et le support de substrat (2, 2a), de préférence peut être introduit entre le guidage de chambre de traitement (1, 1a, 1b, 1c) et le côté avant du support de substrat (2) tourné vers le guidage de chambre de traitement (1, 1a, 1b, 1c).

14. Dispositif de dépôt chimique d'une couche de silicium sur un substrat, avec une chambre de traitement (P) selon l'une quelconque des revendications 1 à 13.

15. Procédé pour guider un support de substrat (2, 2a) dans une position de traitement,
**caractérisé en ce que**
le support de substrat (2, 2a) est guidé dans un guidage de chambre de traitement (1, 1a, 1b, 1c) d'une chambre de traitement (P) selon l'une quelconque des revendications 1 à 13 au moyen d'un roulement à rouleaux,
en particulier **en ce qu'**un gaz de purge est amené entre le support de substrat (2, 2a) et le guidage de chambre de traitement (1, 1a, 1b, 1c), de préférence entre un des côtés avant tourné vers le guidage de chambre de traitement (1, 1a, 1b, 1c) du support de substrat (2, 2a) et le guidage de chambre de traitement (1, 1a, 1b, 1c), de préférence pendant un processus de dépôt.
